# EUROPEAN PATENT APPLICATION

(11) **EP 1 457 824 A1**
(43) Date of publication of application: **15.09.2004**
(21) Application number: 03075750.4
(22) Date of filing: 14.03.2003
(51) Int. Cl.: G03F 7/20

(54) **Lithographic projection apparatus and device manufacturing method**

(71) Applicant: ASML Netherlands B.V., 5503 LA Veldhoven (NL)
(72) Inventor: Teunissen, Franciscus J. H. M., 3043 CC Rotterdam (NL); de Graaf, Roelof F., 5508 MX Veldhoven (NL); Verhagen, Martinus C. M., 5551 HT Valkenswaard (NL); Verspay, Jacobus J. L. H., 6017 BZ Thorn (NL)
(74) Representative: Prins, Adrianus Willem, Mr. Ir.

(57) **Abstract**

In a lithographic projection apparatus the conditioning of gas that is led into the housing of the apparatus is obtained by a single unit (13), in which gas purification and the controlling of the gas temperature by means of heat exchanging takes place in a single unit, wherein the heat exchanger is applied to the outer shell of the purifier. The advantage is that the heat exchanger has not to be of a high purity quality, since there is no risk that leaks in the heat exchanger tubes contaminate the gas flow.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus - commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

Inside a lithographic projection apparatus of the present type high requirements are set for the chemical composition and chemical purity as well as for the temperature and temperature stability of the gas, e.g. nitrogen, helium, argon and eXtremely Clean Dry Air (XCDA) inside the housing of the apparatus, for example in the entire exposure light-path. Conditioning of gasses before they are led into the housing thus is required. In the following the abbreviation UHP (Ultra High Purity) will be used to indicate the quality of the purity of the gas inside the housing of the lithographic projection apparatus.

Up to now gasses to be conditioned first are led through a purifier such as the 700KF from Aeronex, in which undesired substances are removed from the gas stream in a manner known per se, so that at the output of the purifier the gas is of the desired UHP quality.

From the output of the purifier the gas is led into the input of a heat exchanger to bring the gas to the desired temperature (e.g. 22 °C). From the output of the heat exchanger the gas, which is now conditioned, is led into the housing of the lithographic apparatus. The heat exchanger that is employed can be of the tube-in-tube type, e.g. Exergy Model 00528 or of the tube-in-shell type, e.g. Exergy 35 Series, or a plate & fin, e.g. Sumitomo type XS4955. The known conditioning of gasses causes the problem that the heat exchanger has to be of a UHP quality. Such heat exchangers are expensive. Moreover, heat exchangers of the tube-in-shell and plate-and-fin types, even if of UHP quality, have an inherent risk of leakage into and contaminating of the UHP gas flow. This is due to the presence of welded and/or brazed joints in such heat exchangers, at which joints leakage can occur during the life cycle of the heat exchanger. When contaminated gas reaches the interior of the photolithographic apparatus, it is very time consuming and expensive to clean it again and indeed some types of contamination are irreversible, which could in time lead to the loss of, and need to replace, entire lens elements. The associated costs for the replacements as well as the lost production due to machine down-time are severe.
A tube-in-tube heat exchanger with the desired performance would become unacceptably large, since these types of heat exchangers are inherently much less efficient than tube-in-shell or tube-and-fin heat exchangers.

A solution for the above problem, which might present itself to the person skilled in the art, should be to change the order of the two apparatuses in the direction of the gas flow, i.e. to bring the gas to the required temperature first and to purify it afterwards, immediately before the gas enters the housing of the lithographic apparatus. All unwanted substances, introduced in the gas stream by the heat exchanger, then automatically also would be removed from the gas stream in the purifier and the heat exchanger does not necessarily have to be of UHP quality.

This solution, however, also causes problems in that in practice with conventional purifiers it is impossible to guarantee that the temperature of the gas entering the input of the purifier is the same as, or at least within a predetermined margin of, the temperature of the gas at the output of the purifier. The reason for this is that purifiers, apart from being very well suited for purifying gas, also to a certain extent function as heat exchangers. In particular when the difference between the temperature of the ambient air and the temperature of the gas passing through the purifier is large, it is not possible to keep the gas leaving the purifier at the desired temperature. The only solution for this would be to add an additional heat exchanger after the purifier, which would take away the advantage of this solution for the reasons described in the foregoing.

It is an object of the present invention to present a solution for the above-described problem.

This and other objects are achieved according to the invention in a lithographic apparatus as specified in the opening paragraph, characterized in that the lithographic projection apparatus comprises conduit means for introducing gas into the housing of the apparatus, in the conduit means gas purifying means and heat exchanger means being incorporated for conditioning the gas with respect to purity and temperature, and in that the heat exchanger means form part of the purifying means.

According to the invention, in an advantageous manner, use is made of the fact that a gas purifier has heat exchanging capabilities. By conditioning the shell of the purifier, the temperature of the gas leaving the purifier can be controlled in an efficient manner. Moreover, the heat exchanging means have not to conform to any purity standard at all, since it only comes into contact with the outer shell of the purifying means and by no means with the gas. Leakage due to imperfect joints or failing joints will have no impact on the gas purity. In fact any joints in this invention can be made in such a way that structural functions are separated from the heat transfer function, by the judicious use of welded or brazed straps for the former and conducting glues and filler pastes for the latter. By applying the invention there is a significant saving of cost, volume and a minimalization of the failure risk.

According to a first embodiment of the invention, the heat exchanger means form a separate unit that is coupled with the shell of the purifying means, which also form a separate unit. For such coupling, for example, a glue or filler paste with a good heat conductivity can be used.

According to a second embodiment of the invention the heat exchanging means is made as an integral part of the shell of the purifying means. As a practical example of such a second embodiment, a construction similar to that of a cooling cylinder for the lens of a photolithographic apparatus of the present type can be envisaged, wherein a conduit for cooling/heating fluid in a spiral configuration is applied around the shell of the purifying means.

With the known solutions a moisture sensor has to be provided at the output of the heat exchanger to verify that no leaks are present and at the output of the purifier in order to detect a possible saturation of the purifier. A single moisture sensor at the purifier output would be unable to distinguish between the two failure modes. Moreover, moisturized air entering the purifier would consume the purifier very quickly, thus necessitating replacement of this very expensive item.

With the combined purifier/heat exchanger apparatus according to the invention only one moisture sensor is required at the output of the single integrated apparatus. This not only saves money, because such moisture sensors are relatively expensive, but also space and it removes an item that may fail from the system.
It can be advantageous, but not necessary, to surround the entire apparatus with some form of insulation, in order to ensure that the thermal conditioning is applied only to the gas in the conduit and not, or as little as possible, to the ambient air, and thus optimize the efficiency of the system.

According to a further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
characterized by providing an atmosphere of conditioned gas by purifying and heat controlling a gas stream, wherein the purifying and heat controlling takes place in a single unit, comprising purifying means and heat exchanging means.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:
- Figure 1 depicts a lithographic projection apparatus according to an embodiment of the invention;
- Figure 2 schematically shows the gas conditioning means according to the prior art; and
- Figure 3 schematically shows the gas conditioning means according to the invention.

### Embodiment

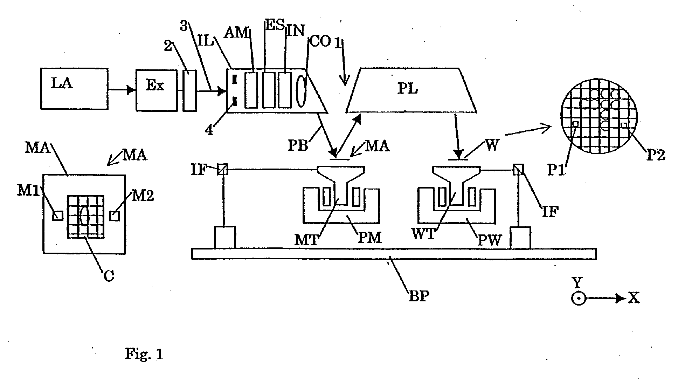

Figure 1 schematically depicts a lithographic projection apparatus 1 according to a particular embodiment of the invention. The apparatus comprises:
- a radiation system Ex, IL, for supplying a projection beam PB of radiation (e.g. light in the deep UV region). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source LA (e.g. an excimer laser source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed *v*, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

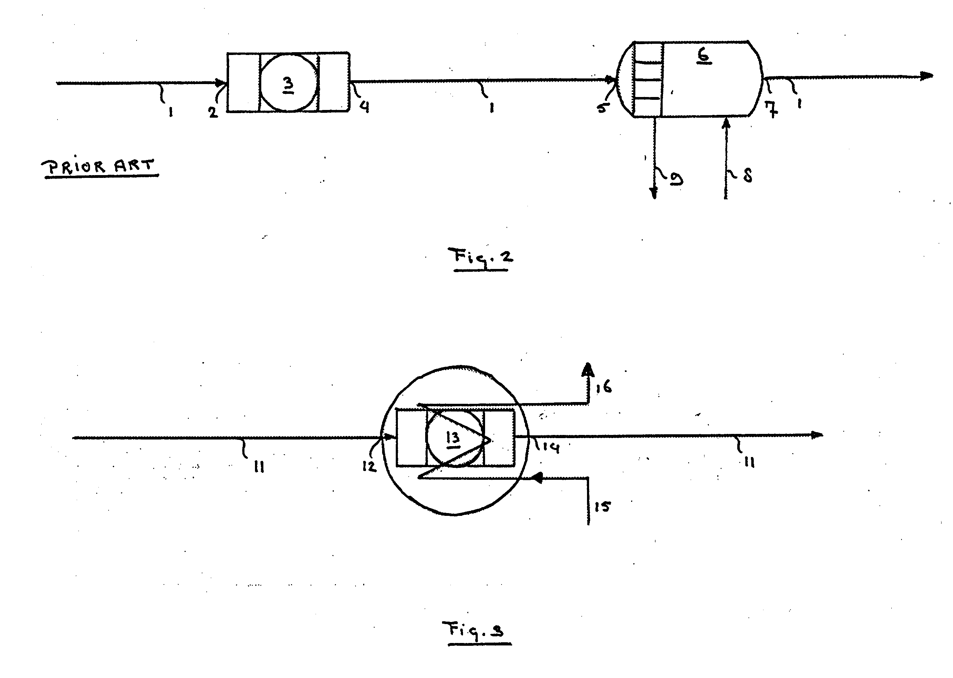

Figure 2 schematically shows the prior art. Through conduit means 1 gas is first led to the input 2 of a purifier 3, which can be of any conventional type, such as a getter purifier, a zeolith purifier or a heated purifier. From the output 4 of the purifier the gas, through the conduit means 1, is led to the input 5 of a heat exchanger 6, which also is of a conventional type. At the output 7 of the heat exchanger the gas in a conditioned form with respect to purity and temperature is available. This prior art solution has the disadvantages described in the introduction to the specification. Also changing the position of the purifier 3 and the heat exchanger 6 in the conduit means does not solve these problems as described. Conduits 8 and 9 are for leading a cooling/heating fluid towards and from the heat exchanger 6.

Figure 3 shows the embodiment according to the invention. In conduit means 11 a combined purifier/heat exchanger apparatus 13 is inserted with an input 12 for gas to be conditioned and an output 14 for the gas that is conditioned with respect to purity and temperature. The apparatus 13 further has an input and output, 15 and 16, respectively, for a cooling/heating fluid, such as water. The conduit connecting input 15 and output 16, for example, can be arranged spirally around the outer shell of the purifier section of the apparatus 13. This purifying section, again, can be of any conventional type.

Whilst specific embodiments of the invention have been described above, it will be appreciated that the invention may be practiced otherwise than as described. The description is not intended to limit the invention.

## Claims

1. A lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate,
**characterized in that** the lithographic projection apparatus comprises conduit means for introducing gas into the housing of the apparatus, in the conduit means gas purifying means and heat exchanger means being incorporated for conditioning the gas with respect to purity and temperature, and **in that** the heat exchanger means form part of the purifying means.

2. Lithographic projection apparatus according to claim 1, **characterized in that** the heat exchanger means form a separate unit that is coupled with the shell of the purifying means, which also form a separate unit.

3. Lithographic projection apparatus according to claim 2, **characterized in that** a spirally shaped conduit for a heating/cooling fluid is applied around the shell of the purifying means.

4. Lithographic projection apparatus according to claim 2 or 3, **characterized in that** a glue or filler paste with good thermal conductivity is applied between the heat exchanger means and the purifying means.

5. Lithographic projection apparatus according to claim 1, **characterized in that** the heat exchanging means is made as an integral part of the shell of the purifying means.

6. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
**characterized by characterized by** providing an atmosphere of conditioned gas by purifying and heat controlling a gas stream, wherein the purifying and heat controlling takes place in a single unit, comprising purifying means and heat exchanging means.
